Europäisches Patentamt

European Patent Office

Office européen des brevets

(11) Publication number: **0 228 207**
**A2**

# EUROPEAN PATENT APPLICATION

(21) Application number: 86309560.0

(22) Date of filing: 09.12.86

(51) Int. Cl.⁴: **G01R 31/28** , **G06F 11/26**

(30) Priority: 17.12.85 US 811128

(43) Date of publication of application:
08.07.87 Bulletin 87/28

(84) Designated Contracting States:
AT BE CH DE ES FR GB GR IT LI LU NL SE

(71) Applicant: ADVANCED MICRO DEVICES, INC.
901 Thompson Place P.O. Box 3453
Sunnyvale, CA 94088(US)

(72) Inventor: Perlman, Robert
2333 Stratford Drive
San Jose California 95124(US)
Inventor: Corry, Alan
21 Bowdoin Street No. 2A
Boston Massachusetts 02114(US)

(74) Representative: Wright, Hugh Ronald et al
Brookes & Martin 52/54 High Holborn
London WC1V 6SE(GB)

(54) **Built-in test circuitry for combinatorial logic.**

(57) A combinatorial logic circuit with built-in test circuitry for testing function blocks in the circuit is described. The test circuitry comprises apparatus for testing a selected function block in a sequence of function blocks, an apparatus for selectively rendering transparent to a test pattern and test results all function blocks upstream of and downstream from the selected function block and an apparatus for isolating faults to selected function blocks. By having the capability of rendering function blocks transparent, specific test patterns and test results can be transmitted to and received from a selected function block without modification thereby improving the testing of function blocks deeply buried within a complex combinatorial circuit.

EP 0 228 207 A2

## BUILT-IN TEST CIRCUITRY FOR COMBINATORIAL LOGIC

The present invention relates to fault detection and isolation circuits in general and to fault detection and isolation circuits for detecting and isolating faults in a large multi-level combinatorial logic circuit in particular.

Many digital logic circuits comprise essentially two types of logic circuits. One type is called a combinatorial logic circuit. The other type is called a sequential logic circuit.

An example of a combinatorial logic circuit is an AND gate comprising a plurality of inputs and an output in which the output is strictly a function of the inputs. Such circuits, in general, are not bistable and consequently do not store data or contain state information.

An example of a sequential logic circuit is a flip-flop comprising a plurality of inputs and a plurality of outputs. In contrast to a combinatorial logic circuit, the outputs of a sequential logic circuit, e.g. flip-flop, are a function of its inputs and its previous state. For example, if a flip-flop is initially set to a logical 1 state, a set 1 input signal will not change the state of the flip-flop. However, if the flip-flop is initially in a logical 0 state, a set 1 input signal will change the flip-flop from its logical 0 state to its logical 1 state. Moreover, the outputs of the flip-flop, regardless of the state to which it has been set or reset, will remain after the inputs are removed.

Many proposals have been made for testing sequential and combinatorial logic circuits used in digital systems. For example, in one such proposal which is restricted to the testing of a digital circuit comprising a single level or a relatively small number of levels of combinatorial logic, the combinatorial logic is sandwiched between a first and a second sequential logic circuit, e.g. a pair of shift registers. In operation, a first test pattern is shifted into the first shift register. After the test pattern is shifted into the first shift register, it is operated on by the combinatorial logic circuit and the results thereof transferred into the second shift register. The results transferred into the second shift register are then compared with a second test pattern. If there is a predetermined correspondence between the results and the second test pattern, the tested circuits are assumed to be operational. If not, the tested circuits are repaired or replaced.

This shift register technique is not suitable for testing more complex digital circuits comprising many levels of combinatorial logic. This technique is unsuitable because it is often difficult to feed an appropriate test pattern from the input or inputs of a large multi-level combinatorial logic circuit to a section of logic buried deep in the circuit. One of the reasons for this difficulty is that logic sections upstream from the section of logic under test often manipulate a test pattern applied to the inputs of the circuit during the normal operation thereof in an unpredictable manner or in such a manner that a desired test pattern simply cannot be generated at the inputs of the section of logic under test. Another reason is that the upstream logic itself may be defective. This problem is one of controllability. Similarly, the logic sections downstream from a logic section under test can so manipulate the output of the logic section under test or can themselves be defective such that the results of the test are indeterminate. This problem is one of observability.

Heretofore, proposals for isolating and detecting faults in deeply buried sections of logic in complex combinatorial logic circuits have generally comprised the use of a 2-to-1 multiplexer coupled to the input and a pass gate coupled to the output of selected logic sections, a test pattern input bus and a test results output bus.

In operation, the input of a selected logic section was isolated from the output of the preceding upstream logic sections by the multiplexer. A test pattern was applied to the input of the section via the test pattern input bus and the multiplexer. The results of the test were passed to the output bus via the pass gate coupled thereto.

A principal disadvantage of the above described prior known method and apparatus for isolating and detecting faults in deeply buried sections of complex combinatorial logic circuits is that a considerable amount of space on the chip is required for the multiplexers, the pass gates and the two test pattern and test result busses.

We will describe a method and apparatus for isolating and detecting faults in deeply buried sections of complex multi-level combinatorial logic circuits which do not require the amount of on-chip hardware of prior known methods and apparatus.

In accordance with this it is recognized that many combinatorial logic circuits can be and are operated normally in such a manner that a data pattern applied to their inputs can be made to appear on their outputs without modification. For example, a combinatorial shifter comprising a plurality of rows of multiplexers is normally capable of shifting data a selected number of bits as a function of control signals applied to normally available control signal inputs. One of the normally available control signal inputs is a zero shift control signal input which when active causes data applied to the input to be passed to the output of the shifter without modification, i.e. without having been shifted. In other words, the shifter can be made to appear "transparent" to data applied to its input with no additional hardware required.

Similarly, combinatorial adders and subtracters and other types of logic circuits can be made to appear transparent with very little additional hardware required by simply providing enough hardware such that during a test a test pattern or test results from another circuit applied to the input of the circuit is provided at the output of the circuit without modification.

To implement fault detection according to the described embodiment of this invention, a multi-level complex combinatorial logic circuit to be tested is first partitioned into function blocks (e.g. adders, shifters, multipliers) and control blocks. The control blocks may comprise, for example, RAM, ROM, PROM, PLA, or a combination thereof. Each function block is then modified, if and as required, to pass data transparently when given an appropriate control command from a control block. For some function blocks, like adders, this "pass" function requires, as indicated above, that the function block be modified by a small amount of additional hardware. For other function blocks, like shifters, no additional hardware is needed since, as mentioned above, a shifter can be made to pass data by supplying it a shift count of zero.

The control blocks are modified to respond to a special set of controls, or a test instruction set, that command all function blocks except the one under test to pass data transparently. In this fashion, data can be fed from input pins of the logic circuit to the function block under test without modification. Similarly, test results from the block under test can be fed to the output pins of the logic circuit without modification. The transparent paths to and from the function block under test provide controllability and observability. Moreover, the necessary changes to the control blocks are made by adding product terms requiring little or no hardware expense.

In addition to providing fault detection, the present arrangement also provides fault isolation with a minor addition of hardware to otherwise conventional combinatorial logic circuits. By passing a test result output bus through all function blocks, and by adding 3-state drivers from the output of each block to the bus, the test result from any function block can be observed directly, i.e. without passing through any other function block. Therefore, by testing function blocks in a predetermined sequence a fault can be detected and isolated to a particular function block. For example, if the first function block in the sequence is found to be without a fault, that block is rendered transparent to pass a test pattern applied to its inputs which is appropriate for testing the next function block in the sequence to the input of the next function block in the sequence without modification. If the next function block in the sequence is found to be free of faults it and the previously tested function block are rendered transparent to a test pattern appropriate to the following function block and so on until all blocks have been tested. In this manner, the space for multiplexers and a test pattern input bus as required in prior known apparatus is saved for other purposes.

In an alternate embodiment of the present invention, data is injected into the function blocks by 2:1 multiplexers. In this embodiment the blocks are tested and rendered transparent in a reverse sequence to effect fault detection and isolation with the test results observed on the outputs of the first block test after each test. For example, after each function block is tested and found to be free of faults, beginning with the last function block in a predetermined sequence, all function blocks downstream of the function block under test are rendered transparent to the test results from the function block under test. In this manner, the space for a test results bus as required in prior known apparatus is saved for other purposes.

## Brief Description of the Drawing

The above and other objects, features and advantages of the present invention will become apparent from the following detailed description of the accompanying drawing in which:

Fig. 1 is a block diagram of an embodiment of the present invention;

Fig. 2 is a block diagram of a multiplier according to the present invention;

Fig. 3 is a block diagram of an adder according to the present invention;

Fig. 4 is a block diagram of a three level shifter, a shifter control circuit and test instruction decoder according to the present invention;

Fig. 5 is a block diagram of the three level shifter of Fig. 4;

Fig. 6 is a diagram of the outputs of each of the levels of the three level shifter of Fig. 5;

Fig. 7 is a block diagram of a fault isolation circuit according to the present invention;

Figs. 8 and 9 are block diagrams of an alternative three level shifter, a shifter control circuit and test instruction decoder according to the present invention; and

Fig. 10 is a block diagram of an alternative embodiment of a fault isolation circuit according to the present invention.

### Detailed Description of the Drawing

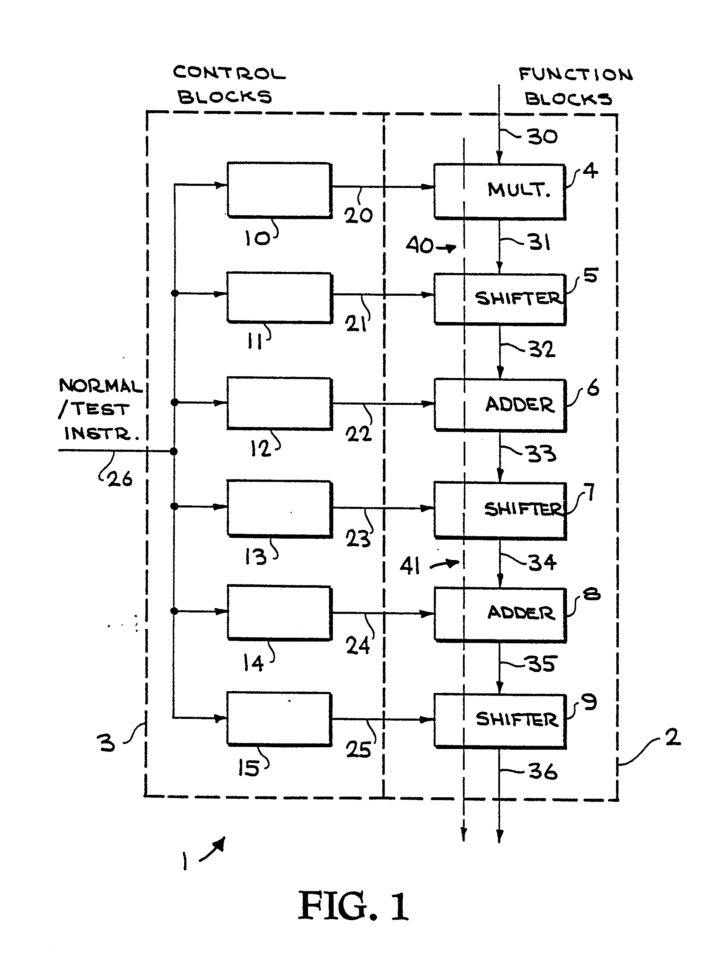

Referring to Fig. 1, there is provided in accordance with a first embodiment of the present invention a large multilevel combinatorial logic circuit designated generally as 1. To facilitate describing the invention, the circuit 1 is shown divided into a plurality of function blocks 2 and a plurality of control blocks 3. Among the function blocks 2 there is illustrated a multiplier 4, a shifter 5, an adder 6, a shifter 7, an adder 8, and a shifter 9. The control blocks 3 comprise a plurality of control blocks 10-15. The control blocks 10-15 are coupled to the function blocks 4-9 by means of a plurality of control signal buses 20-25. Normal instructions and test instructions are provided to the control blocks 10-15 on an instruction bus 26.

Coupled to the data inputs and data outputs of the function blocks 4-9, there is provided a plurality of data buses which are represented by a plurality of single unbroken arrows 30-36. The unbroken arrows 30-36, in addition to representing data buses, more importantly represent the flow of data through the circuits 4-9 as the data is processed therein in a conventional manner in response to normal arithmetic and logic instructions under the control of the control blocks 10-15. For example, a pair of operands on the data buses represented by the unbroken arrow 30 is processed in the multiplier 4 and the resulting operand is then placed on the data bus represented by the arrow 31 for processing in the shifter 5. After the data is processed in the shifter 5, it is placed on the data bus 32 for processing in the adder 6. Once again, while only a single unbroken arrow 32 is shown coupling the shifter 5 and adder 6, it is to be understood that at least two data buses are required for providing at least two operands to the adder 6. After processing in the adder 6, the data is further processed sequentially in the circuits 7-9 in a conventional manner.

To the left of the unbroken arrows 30-32 and 33-36, there is shown a pair of broken arrows 40 and 41. The body of the broken arrow 40 is shown passing through the circuits 4 and 5 and having a head terminating at the data input of the adder 6. The body of the broken arrow 41 is shown commencing at the data output of the adder 6 and passing through the circuits 7, 8 and 9. The purpose of the broken arrow 40 is to show that during testing of the adder 6, when only adder 6 is being operated in a conventional manner under the control of the control block 12, the circuits 4 and 5 upstream of the adder 6 are rendered transparent to a test pattern applied to the data buses represented by the arrow 30 under the control of the control blocks 10 and 11. Similarly, the purpose of the broken arrow 41 is to show that during testing of the adder 6, the circuits 7-9 downstream of the adder 6 are rendered transparent to the test results resulting from the testing of the adder 6 which are applied to the data bus represented by the arrow 33 under the control of the control blocks 13-15.

As will become apparent from the following description, there is provided in the otherwise conventional multiplier 4 and adders 6 and 8 a number of pass gates to enable these circuits to be rendered transparent to a test pattern and test results applied to their data inputs. The shifters 5, 7 and 9 require no additional hardware.

Similarly, in each of the control blocks 10-15, there is provided, in addition to conventional instruction decoding circuitry which is used for causing a circuit controlled thereby to operate in a conventional manner, simple test instruction decoding circuitry for generating a control signal PASS A to cause the circuit to operate in either a conventional manner or to pass data transparently.

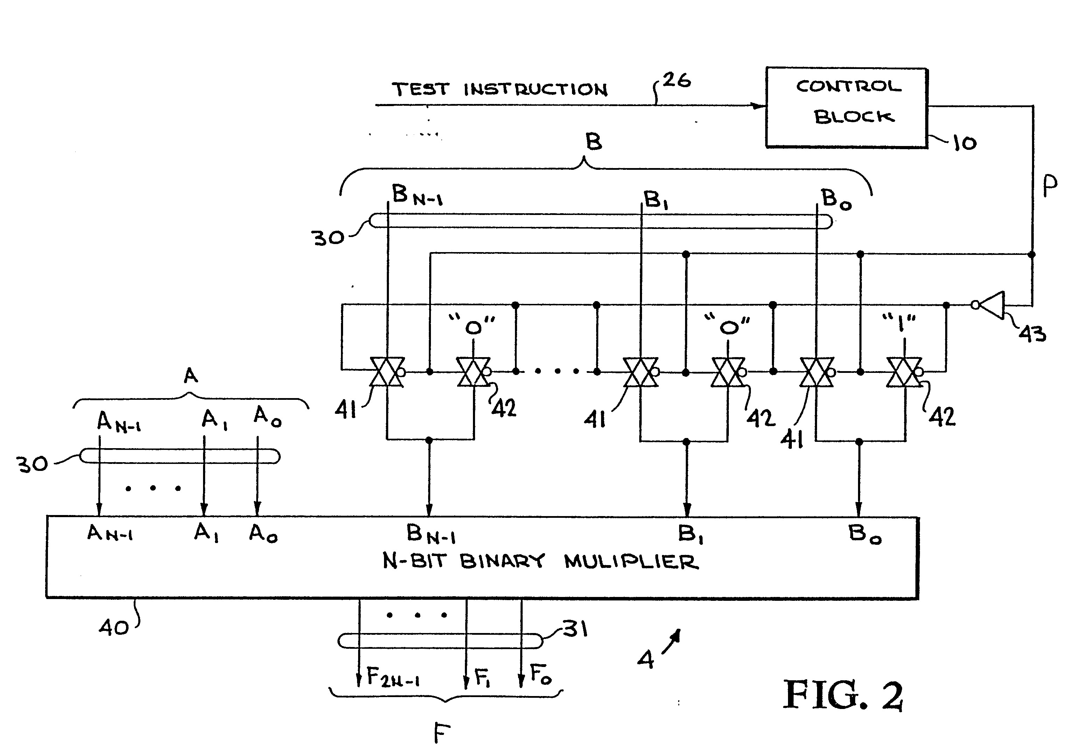

Referring to Fig. 2, there is provided in the multiplier 4 an N-bit combinatorial binary multiplier 40 having a plurality of inputs $A_{N-1}$ -$A_0$ and $B_{N-1}$ -$B_0$ for receiving a pair of N-bit operands A and B on the bus 30, and a plurality of data outputs $F_{2N-1}$ -$F_0$ for providing an output operand F on the bus 31. Coupled in series with each of the inputs $B_{N-1}$ -$B_0$ there is provided a pair of pass gates 41 and 42. Each of the pass gates 41 is provided with an input for receiving one of the bits of the operand B, a first control signal input coupled through an inverter 43 to the control signal bus 20 and a second inverted control signal input coupled directly to the control signal bus 20. Each of the pass gates 42, except for the pass gate coupled to input $B_0$, is provided with an input for receiving a logical 0. The pass gate 42 coupled to the input $B_0$ is provided with an input for receiving a logical 1. Each of the pass gates 42 is provided with a first control signal input which is coupled directly to the control signal bus 20 and a second inverted control signal input which is coupled through the inverter 43 to the control signal bus 20.

In operation, when the multipler 4 is to be tested, the control block 10 generates a $\overline{PASS\ A}$ control signal on the bus 20 in response to a test instruction. The $\overline{PASS\ A}$ control signal causes the pass gates 41 to pass the bits $B_{N-1}$ -$B_0$ of the operand B to the multiplier 40 so that the operands A and B are processed in the multipler 40 in a conventional manner.

During the testing of other circuits in the circuit 1 in response to another test instruction, the control block 10 generates a PASS A control signal on the bus 20 in response to the latter instruction. The control signal PASS A causes the pass gates 42 to pass logical 0's to the inputs $B_{N-1}$ -$B_1$ and a logical

1 to input $B_0$. Thereafter, the operand A is multiplied by the operand B which now has a value of unity, thus, in effect rendering the multiplier 40 transparent to the operand A. That is, the operand A, which will comprise a test pattern for a downstream circuit, will be transferred from the input data bus 30 to the output data bus 31 without modification.

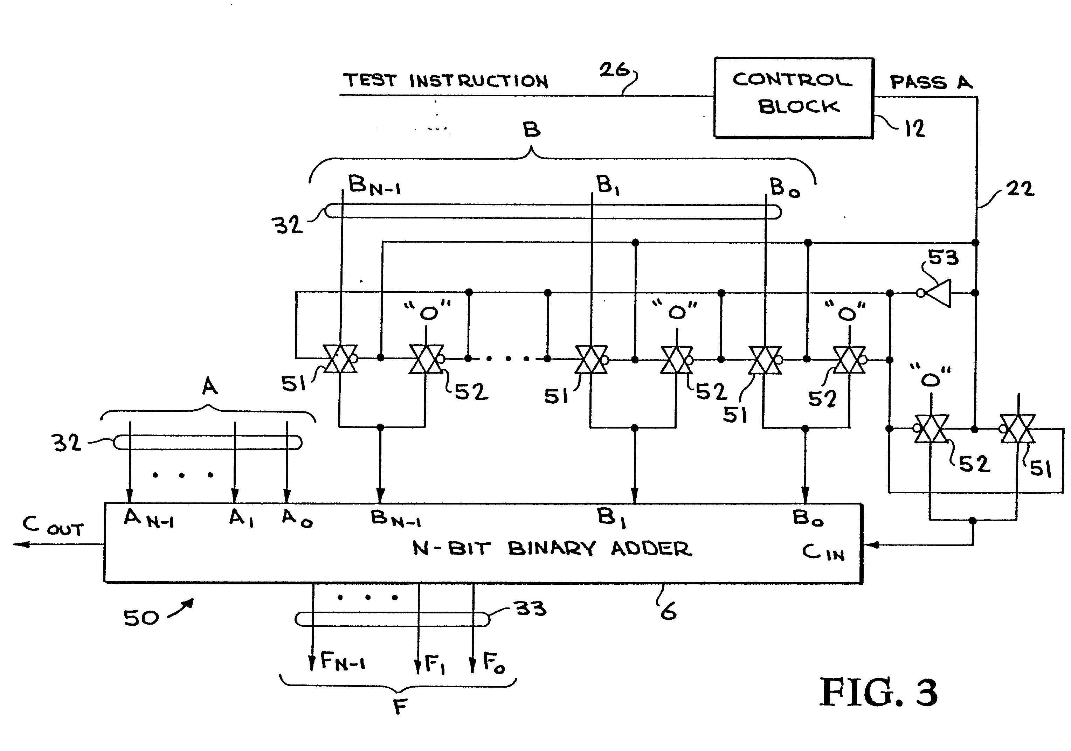

Referring to Fig. 3, there is provided in the adder 6 an N-bit combinatorial binary adder 50 having a plurality of inputs $A_{N-1}$ -$A_0$ and $B_{N-1}$ -$B_0$ for receiving a pair of N-bit operands A and B on the bus 32, a carry-in input $C_{IN}$, a carry-out output $C_{OUT}$, and a plurality of data outputs $F_{N-1}$ -$F_0$ for providing an output operand F on the bus 33. Coupled in series with each of the inputs $B_{N-1}$ -$B_0$ and $C_{IN}$ there is provided a pair of pass gates 51 and 52. Each of the pass gates 51 is provided with an input for receiving one of the bits of the operand B, a first control signal input coupled through an inverter 53 to the control bus 22 and a second inverted control signal input coupled directly to the control signal bus 22. Each of the pass gates 52 is provided with an input for receiving a logical 0, a first control signal input which is coupled directly to the control signal bus 22 and a second inverted control signal input coupled to the control signal bus 22 through the inverter 53.

In operation, when the adder 50 is to be tested, the control block 12 generates a $\overline{PASS\ A}$ control signal on the bus 22 in response to a test instruction. The control signal $\overline{PASS\ A}$ causes the pass gates 51 to pass the bits $B_{N-1}$ -$B_0$ of the operand B and $C_{IN}$ to the adder 50 so that the operands A and B are processed in the adder 50 in a conventional manner.

During the testing of the other circuits in the circuit 1 in response to another test instruction, the control block 12 generates a PASS A control signal on the bus 22 in response to the latter test instruction. The control signal PASS A causes the pass gates 52 to pass logical 0's to the inputs $B_{N-1}$ -$B_0$ and $C_{IN}$. Thereafter, the logical 0's are added to operand A in a conventional manner, thus in effect, rendering the adder 50 transparent to the operand A. That is, the operand A, which will comprise a test pattern for a downstream circuit or the test results from an upstream circuit, will be transferred from the input data bus 32 to the output data bus 33 without modification.

Referring to adder 8 of Fig. 1, it should be noted that the apparatus described above for selectively rendering the adder 6 transparent is also used for selectively rendering the adder 8 transparent in the same manner.

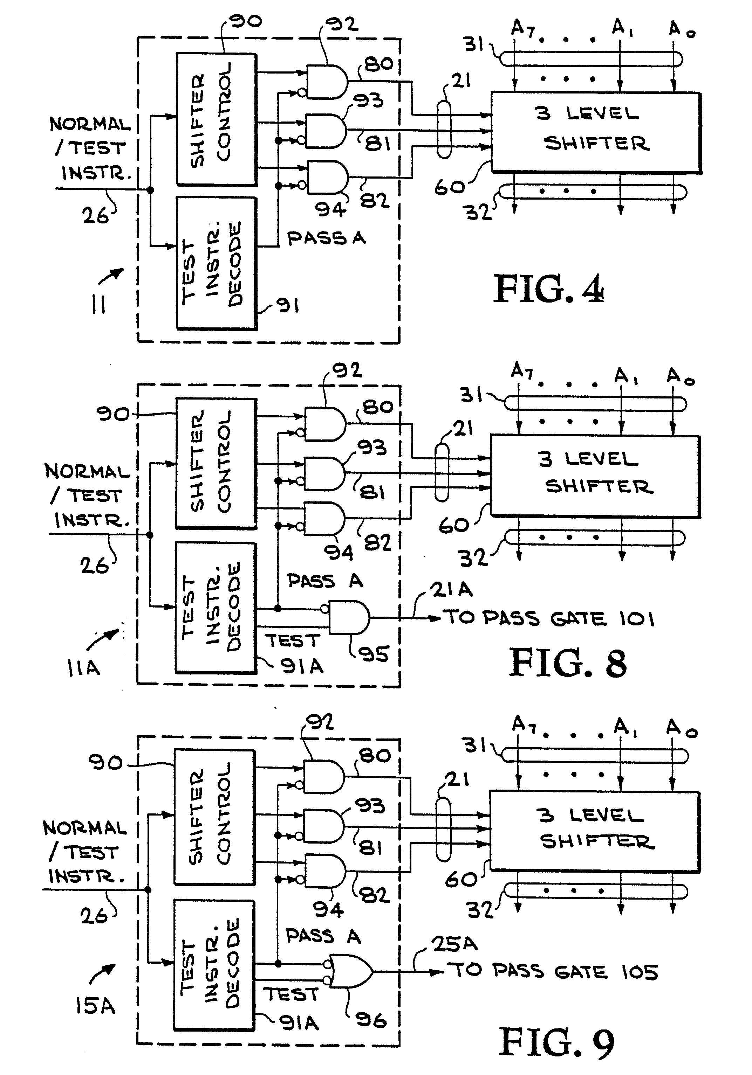

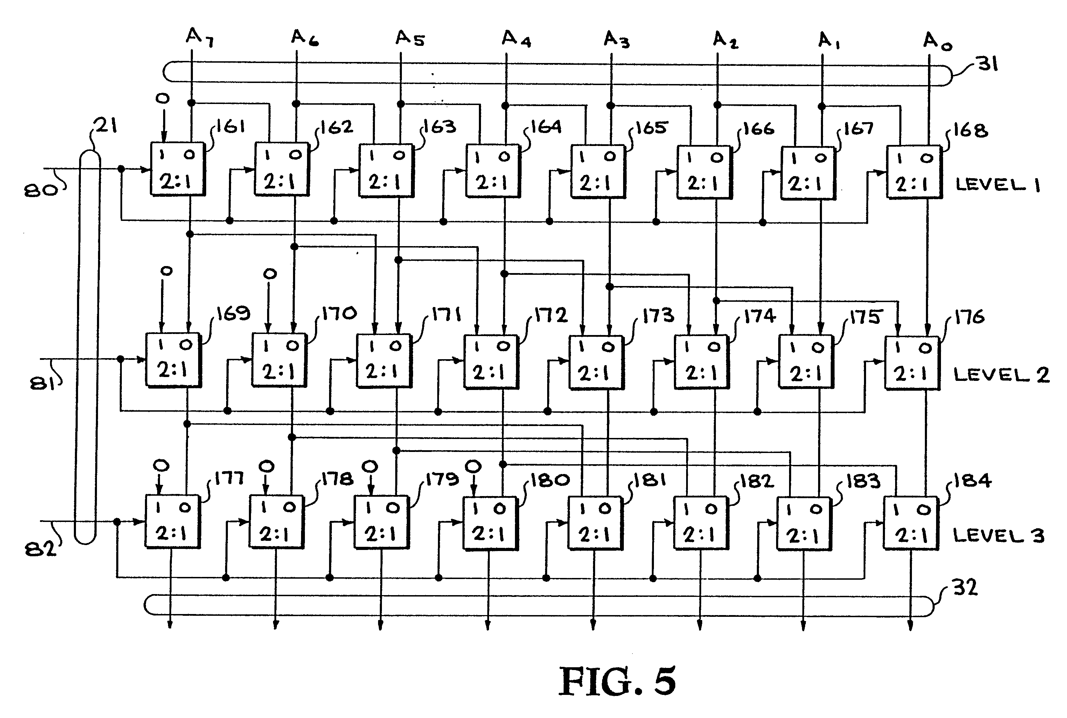

Referring to Figs. 4-6, there is provided in the shifter 5, an N-bit, multilevel shifter 60 having a plurality of inputs $A_7$ -$A_0$ for receiving an 8-bit operand A on the data input bus 31 and a plurality of outputs coupled to the output bus 32. This shifter 60 is described as being 8 bits wide for ease of illustration, but the discussion that follows applies equally well to shifters of arbitrary width.

In the shifter 60 there is provided a plurality of 2:1 multiplexers 161-184. The multiplexers 161-184 are arranged in three rows designated levels 1, 2 and 3. A plurality of control signal buses 80-82 are coupled to each of the multiplexers in the levels 1, 2 and 3, respectively, for selectively coupling one of the two inputs of each multiplexer and its output. To facilitate a description of the operation of the shifter 60, as will be provided below, the inputs of each of the multiplexers 161-184 are designated with a logical 1 and 0.

In the control block 11, there is provided a conventional shifter control circuit 90, a conventional test instruction decoding circuit 91 and a plurality of AND gates 92, 93 and 94. The inputs of the circuits 90 and 91 are coupled to the instruction bus 26. The outputs of the circuit 90 are coupled to a first input of the AND gates 92-94. The outputs of the circuit 91 are coupled to an inverting input of the AND gates 92-94. The outputs of the AND gates are coupled to the control signal buses 80-82, respectively.

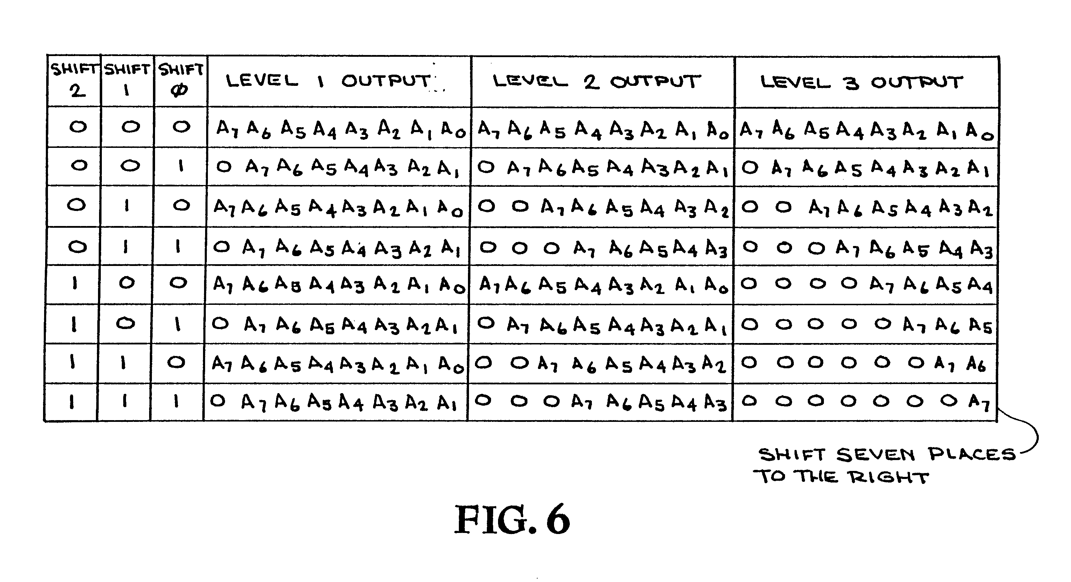

In operation, when the shifter 60 is to be tested, the circuit 91 in the control block 11 generates a $\overline{PASS\ A}$ control signal which enables the AND gates 92-94 and the circuit 90 outputs a shift control signal in response to a test instruction. If the shift control signal calls for shifting the input 7 places to the right, a logical 1 will be placed on the control buses 80-82 by the circuit 90 causing the input 1 of all of the multiplexers 161-184 to be coupled to their output. Under these conditions, an input of $A_7$, 0, 1, 0, 0, 0, 0, 0 on the bus 31 will appear on the bus 32 as $0000000A_7$, as shown in Fig. 6.

During the testing of the other circuits in the circuit 1 in response to another test instruction, circuit 91 outputs a PASS A control signal which disables the AND gates 92-94. The resulting logical 0 on the control signal buses 80-82 couples the input 0 of the multiplexers to their output rendering the shifter 60 transparent and causing the operand $A_7$ -$A_0$ on the bus 31, which may be a test pattern for a downstream circuit or test results from an upstream circuit, to appear on the bus 32 without modification.

Referring to shifters 7 and 9 of Fig. 1, it should be noted that the apparatus described above for selectively rendering the shifter 5 transparent is also used for selectively rendering the shifters 7 and 9 transparent. Of course, appropriate modifications should be made if the number of levels in shifters 7 and 9 are more or less than three.

Referring to Fig. 1, the overall operation of the circuit 1 in accordance with the present invention will now be described. In a typical test procedure, the function blocks 4-9 are tested in sequence using a test pattern specially designed for that purpose beginning with the multiplier 4. As each of the function blocks is checked and found to be free of faults, it is rendered transparent to a test pattern specially designed for testing the next and succeeding function blocks in the sequence.

At the same time as each function block is being tested, all function blocks downstream of the function block being tested are rendered transparent. This enables the test results to be transferred from the function block being tested to an external circuit, such as a register, without modification, thus facilitating an evaluation of the test results.

The circuit 1 of Fig. 1 and the apparatus of Figs. 2-5 are useful for detecting faults in deeply buried logic circuits. It should be noted, however, that because the circuits downstream of a circuit under test may be faulty and thereby affect the test results from an upstream circuit even though control signals are generated for rendering these circuits transparent, it is not possible to reliably isolate a fault which has been detected in the circuit 1.

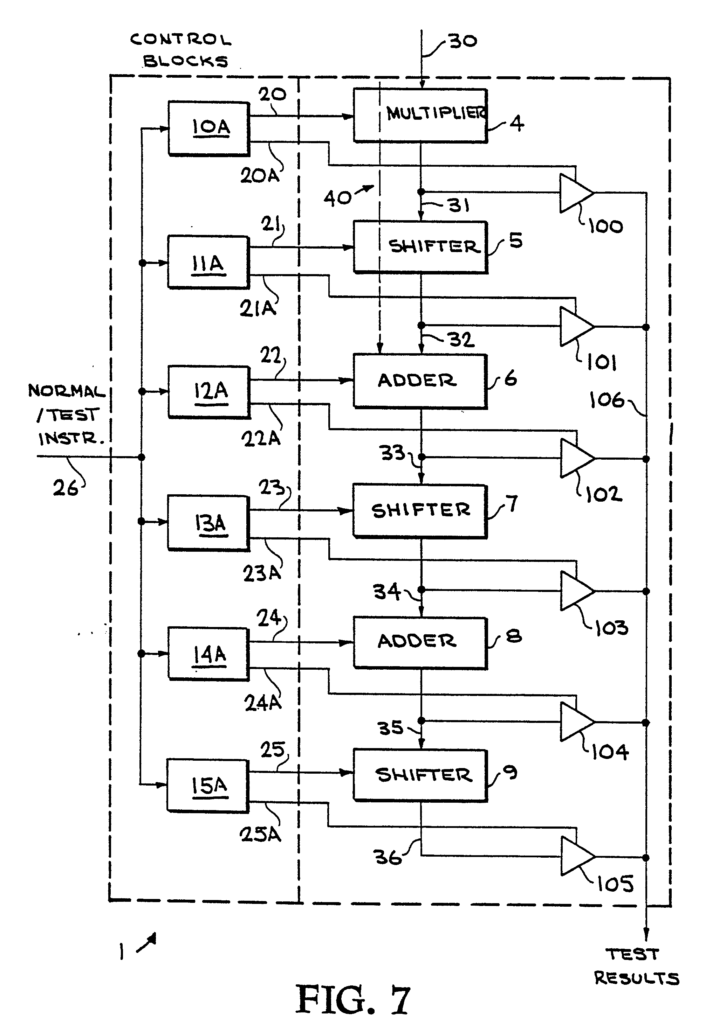

In Figs. 7-10 there are shown two modifications of the apparatus of Fig. 1 which may be used for isolating a fault to a specific function block regardless of how deeply buried the function block is in the logic circuit. For convenience, all circuits which are the same or substantially the same as the circuits of Fig. 1 will be identified in Figs. 7-10 using the same numerical designators.

Referring to Figs. 7-9, there is provided in another embodiment of the present invention a plurality of control blocks 10A-15A, a plurality of function blocks 4-9 which are identical to function blocks 4-9 of Fig. 1, and a plurality of pass gates 100-105.

In each of the control blocks 10A-15A there is provided a control circuit, a test instruction decoder and a plurality of gates for controlling the operation of the function blocks 4-9 as described above with respect to Figs. 1-6 and the pass gates 100-105. For example, in control block 11A there is provided a control shifter circuit 90, and a plurality of AND gates 92-94 which are identical to and function in the same manner as the circuit 90 and gates 92-94 of Fig. 4, a test instruction decoder 91A and an

AND gate 95. The decoder 91A is identical to the circuit 91 of Fig. 4 except that an additional output is provided for providing a test control signal TEST. The control signal PASS A is coupled to an inverted input and the control signal TEST is coupled to a non-inverted input of the AND gate 95. The output of the AND gate 95 is coupled to the control signal line 21A for controlling the pass gate 101.

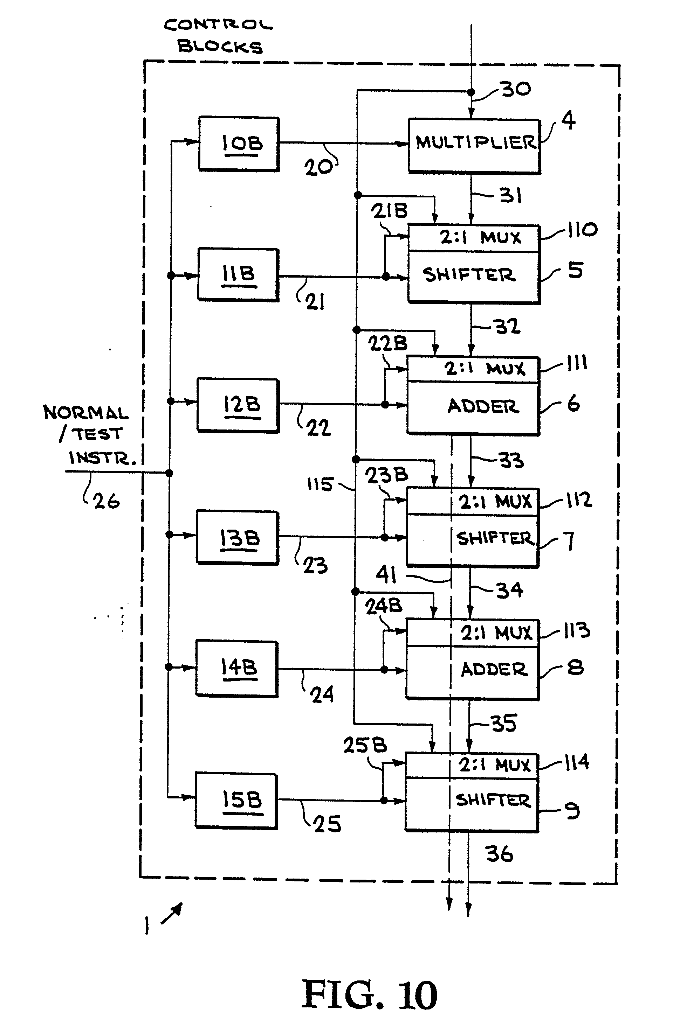

Referring to Fig. 9, in the control block 15A, the AND gate 95 of Fig. 8 is replaced by an OR gate 96 having a pair of inverted inputs for receiving the control signals PASS A and TEST. The output of OR gate 96 is coupled to control signal line 25A for controlling pass gate 105.

It should be understood that the control blocks for the multiplier 4, and adders 6 and 8 will comprise an arrangement of gates consistent with the required control signals as described above with respect to Figs. 2 and 3.

The inputs of the pass gates 100-105 are coupled to data buses 31-36, respectively. The ouputs of the pass gates 100-105 are coupled to a results bus 106. The control signal inputs of the pass gates 100-105 are coupled to the control signal buses 20-25, respectively.

In operation, the pass gates 100-104 are enabled by a control signal corresponding to $\overline{PASS\ A} \cdot TEST$ and pass gate 105 are enabled by a control signal corresponding to $\overline{TEST} + \overline{PASS\ A}$ .

To the left of the solid arrows 31-32 there is shown the broken arrow 40 of Fig. 1. The broken arrow 41 of Fig. 1 is not shown. This is to illustrate that the adder 6 is assumed to be the circuit being tested, that all circuits upstream from the adder 6 are rendered transparent during the testing of the adder 6 and that the test results from the adder 6 are transferred to the output of the circuit 1 via the pass gate 102 and results bus 106 bypassing the untested downstream function blocks.

It is apparent from the foregoing description that each of the function blocks of the apparatus of Fig. 7 is preferably tested in sequence beginning with the multiplier 4 and that the results of each test are transmitted to a test evaluation circuit (not shown) via the results bus 106. Upon completion of a test, the function block tested is rendered transparent and the next function block in the sequence is tested. Since the results of each test bypass the untested downstream function blocks, faults in the downstream function blocks will not affect the results of the test. Consequently, faults in the apparatus of Fig. 7 are readily and reliably isolated.

Referring to Fig. 10, there is provided in another embodiment of the present invention a plurality of control blocks 10B-15B, a plurality of function blocks 4-9, which are identical to function blocks 4-9 of Fig. 1, and a plurality of 2:1 multiplexers 110-114. Each of the multiplexers 110-114 have a first input coupled to the output of the function block upstream therefrom, a second input coupled to a test pattern input bus 115, an output coupled to the input of the function block downstream therefrom, and a control signal input coupled to the control signal bus of the downstream function block.

In the control blocks 10B-15B, the circuit used for generating the control signal $\overline{PASS\ A}$ • TEST described above with respect to the apparatus of Fig. 8 , is also used for generating the control signals for selecting the inputs 21B-25B of the multiplexers 110-114. In operation, in response to the control signal $\overline{PASS\ A}$ • TEST, the multiplexer immediately upstream therefrom in the embodiment of Fig. 10 couples its second input from the test pattern bus 115 to its output. When the control signal $\overline{PASS\ A}$ • TEST is inactive, the first input of the multiplexer coupled to the upstream function block is coupled to its output.

To the left of the unbroken arrows 33-36 there is shown the broken arrow 41 of Fig. 1. The broken arrow 40 of Fig. 1 is not shown. This is to illustrate that the adder 6 is assumed to be the circuit being tested, that all circuits upstream of the adder 6 are bypassed by the test pattern bus 115, that all circuits downstream of the adder 6 have been tested, found free of faults and rendered transparent and that the test results from the adder 6 are transferred from the adder 6 through the circuits 7-9 without modification to be evaluated in an external circuit (not shown).

In operation, the circuit 1 of Fig. 8, like the circuits described above, is operable in a normal mode and in a test mode. In the normal mode the control blocks 10-15, in response to a normal instruction, enable the first input of the multiplexers 110-114 to allow the function blocks 5-9 to operate on data applied to their inputs in a normal manner under the control of the normal instruction.

In the test mode, the function blocks described above with respect to the circuits of Figs. 1 and 7 are tested in a reverse order. That is, to begin a test of the circuit 1, a test pattern is provided by means of the test pattern input bus 115 and the second input of the multiplexer 114 to the last function block in the sequence, i.e. shifter 9. After the function block 9 has been tested and found free of defaults another test instruction is applied to the control blocks 10-15. This test instruction enables an appropriate test pattern to be passed by means of the test pattern input bus 115 through the second input of the multiplexer 113 to the inputs of the adder 8. This causes the adder 8 to operate on the test pattern in a normal manner and at the same renders the downstream function block 9 transparent to the results of the test such that the test results are transferred through the function block 9 without modification.

Each of the function blocks in the sequence are tested in the above described manner such that all function blocks downstream from the function block being tested are rendered transparent while the function block being tested is caused to operate on a test pattern applied to its inputs by means of the test pattern input bus 115 and the 2:1 multiplexer coupled thereto in a normal manner.

Since the results of each test are transferred only through circuits which have been tested and found free of faults and the test pattern is caused to bypass all untested circuits, faults in the apparatus of Fig. 8 are easily detected and reliably isolated to specific function blocks.

While several embodiments of the present invention are described above, it is contemplated that various modifications may be made thereto without departing from the spirit and scope of the present invention. For example, while specific types of function blocks are identified and described, it is to be understood that the present invention may be used with any type of function block comprising combinatorial logic and that the present invention should not be considered to be limited to the types of function blocks described nor should it be limited to function blocks which are coupled in a sequence as described. Moreover, it should also be understood that for certain types of function blocks in which it is not practical to add sufficient hardware to render them transparent during a testing procedure that multiplexers and pass gates may be used separately or in combination to bypass those function blocks. Accordingly, the scope of the invention should not be limited to the embodiments described, but rather be determined by reference to the claims hereinafter provided.

## Claims

1. A method of testing a combinatorial logic circuit comprising a data input, a data output, a plurality of function blocks coupled together between said data input and said data output of said logic circuit, each of said function blocks comprising a data input and a data output and combinatorial logic for performing a predetermined logic function and a plurality of control blocks, each of said control blocks comprising logic for generating control signals to control the operation of at least one of said function blocks, comprising the steps of:

applying a test pattern to said data input of said combinatorial logic circuit;

rendering transparent to said test pattern all of said function blocks located between said data input of said combinatorial logic circuit and said data input of a selected one of said function blocks for transferring said test pattern without modification from said data input of said logic circuit to said data input of said selected function block;

performing the function of said selected function block on said test pattern for generating on said data output of said selected function block a test result corresponding to the operability of said selected function block; and

transferring said test result from said data output of said selected function block to said data output of said logic circuit for purposes of evaluating said test result.

2. A method according to claim 1 wherein said latter transferring step comprises the step of rendering transparent to said test result all of said function blocks located between said data output of said selected function block and said data output of said logic circuit for transferring said test result without a modification thereof from said data output of said selected function block to said data output of said logic circuit.

3. A method according to claim 1 wherein said latter transferring step comprises the step of transferring said test result without a modification thereof to said data output of said logic circuit by means of a pass gate coupled between said data output of said selected function block and said data output of said logic circuit.

4. A method of testing a combinatorial logic circuit comprising a data input, a data output, a plurality of function blocks coupled together between said data input and said data output of said logic circuit, each of said function blocks comprising a data input and a a data output and combinatorial logic for performing a predetermined logic function and a plurality of control blocks, each of said control blocks comprising logic for generating control signals to control the operation of at least one of said function blocks, comprising the steps of:

applying a test pattern to said data input of a selected one of said function blocks;

performing the function of said selected function block on said test pattern for generating on said data output of said selected function block a test result corresponding to the operability of said selected function block; and

rendering transparent to said test result all of said function blocks located between said data output of said selected function block and said data output of said logic circuit for transferring said test result without modification thereof from said data output to said selected function block to said data output of said logic circuit.

5. A method according to claim 4 wherein said applying step comprises the step of applying said test pattern to said data input of said selected function block by means of a multiplexer coupled between said data input of said logic circuit and said data input of said selected logic block.

6. An apparatus for testing a combinatorial logic circuit comprising a data input, a data output, a plurality of function blocks coupled together between said data input and said data output of said logic circuit, each of said function blocks comprising a data input and a data output and combinatorial logic for performing a predetermined logic function and a plurality of control blocks, each of said control blocks comprising logic for generating control signals to control the operation of at least one of said function blocks, comprising:

means for applying a test pattern to said data input of said combinatorial logic circuit; means for rendering transparent to said test pattern all of said function blocks located between said data input of said combinatorial logic circuit and said data input of a selected one of said function blocks for transferring said test pattern without modification thereof from said data input of said logic circuit to said selected function block;

means for causing said selected function block to operate on said test pattern to generate on said data output of said selected function block a test result corresponding to the operability of said selected function block; and

means for transferring said test result from said data output of said selected function block to said data output of said logic circuit for purposes of evaluating said test result.

7. An apparatus according to claim 6 wherein said latter transferring means comprises means rendering transparent to said test result all of said function blocks located between said data output of said selected function block and said data output of said logic circuit to transfer said test result without a modification thereof from said data output of said selected function block to said data output of said logic circuit.

8. An apparatus according to claim 6 wherein said latter transferring means comprises a pass gate coupled between said data output of said selected function block and said data output of said logic circuit for transferring said test result without modification thereof from said data output of said selected function block to said data output of said logic circuit.

9. An apparatus for testing a combinatorial logic circuit comprising a data input, a data output, a plurality of function blocks coupled together between said data input and said data output of said logic circuit, each of said function blocks comprising a data input and a data output and combinatorial logic for performing a predetermined logic function and a plurality of control blocks, each of said control blocks comprising logic for generating control signals to control the operation of at least one of said function blocks, comprising:

means for applying at test pattern to said data input of a selected one of said function blocks;

means for causing said selected function block to operate on said test pattern to generate on said data output of said selected function block a test result corresponding to the operability of said selected function block; and

means for rendering transparent to said test result all of said function blocks located between said data output of said selected function block and said data output of said logic circuit to transfer said test result without a modification thereof from said data output of said selected function block to said data ouput of said logic circuit.

10. An apparatus according to claim 9 wherein said applying means comprises a multiplexer coupled between said data input of said logic circuit and said data input of said selected function block for applying said test pattern to said data input of said selected function block.

FIG. 1

TEST INSTRUCTION  26  | CONTROL BLOCK | 10

B

$B_{N-1}$    $B_1$    $B_0$

30

P

"O"    "O"    "1"

43

A

$A_{N-1}$  $A_1$  $A_0$

30

41    42    41    42    41    42

$A_{N-1}$    $A_1$  $A_0$    $B_{N-1}$    $B_1$    $B_0$

N-BIT BINARY MULIPLIER

40

31

$F_{2N-1}$  $F_1$  $F_0$

4

F

FIG. 2

FIG. 3

0 228 207

0 228 207

FIG. 4

FIG. 8

FIG. 9

FIG. 5

| SHIFT 2 | SHIFT 1 | SHIFT 0 | LEVEL 1 OUTPUT | LEVEL 2 OUTPUT | LEVEL 3 OUTPUT |
|---|---|---|---|---|---|
| 0 | 0 | 0 | $A_7\ A_6\ A_5\ A_4\ A_3\ A_2\ A_1\ A_0$ | $A_7\ A_6\ A_5\ A_4\ A_3\ A_2\ A_1\ A_0$ | $A_7\ A_6\ A_5\ A_4\ A_3\ A_2\ A_1\ A_0$ |
| 0 | 0 | 1 | $0\ A_7\ A_6\ A_5\ A_4\ A_3\ A_2\ A_1$ | $0\ A_7\ A_6\ A_5\ A_4\ A_3\ A_2\ A_1$ | $0\ A_7\ A_6\ A_5\ A_4\ A_3\ A_2\ A_1$ |
| 0 | 1 | 0 | $A_7\ A_6\ A_5\ A_4\ A_3\ A_2\ A_1\ A_0$ | $0\ 0\ A_7\ A_6\ A_5\ A_4\ A_3\ A_2$ | $0\ 0\ A_7\ A_6\ A_5\ A_4\ A_3\ A_2$ |
| 0 | 1 | 1 | $0\ A_7\ A_6\ A_5\ A_4\ A_3\ A_2\ A_1$ | $0\ 0\ 0\ A_7\ A_6\ A_5\ A_4\ A_3$ | $0\ 0\ 0\ A_7\ A_6\ A_5\ A_4\ A_3$ |
| 1 | 0 | 0 | $A_7\ A_6\ A_5\ A_4\ A_3\ A_2\ A_1\ A_0$ | $A_7\ A_6\ A_5\ A_4\ A_3\ A_2\ A_1\ A_0$ | $0\ 0\ 0\ 0\ A_7\ A_6\ A_5\ A_4$ |
| 1 | 0 | 1 | $0\ A_7\ A_6\ A_5\ A_4\ A_3\ A_2\ A_1$ | $0\ A_7\ A_6\ A_5\ A_4\ A_3\ A_2\ A_1$ | $0\ 0\ 0\ 0\ 0\ A_7\ A_6\ A_5$ |
| 1 | 1 | 0 | $A_7\ A_6\ A_5\ A_4\ A_3\ A_2\ A_1\ A_0$ | $0\ 0\ A_7\ A_6\ A_5\ A_4\ A_3\ A_2$ | $0\ 0\ 0\ 0\ 0\ 0\ A_7\ A_6$ |
| 1 | 1 | 1 | $0\ A_7\ A_6\ A_5\ A_4\ A_3\ A_2\ A_1$ | $0\ 0\ 0\ A_7\ A_6\ A_5\ A_4\ A_3$ | $0\ 0\ 0\ 0\ 0\ 0\ 0\ A_7$ |

SHIFT SEVEN PLACES TO THE RIGHT

# FIG. 6

0 228 207

FIG. 7

CONTROL
BLOCKS

| | |
|---|---|
| 10B | MULTIPLIER — 4 |
| 20 | 30 |
| 11B | 2:1 MUX — 110 |
| 21B | SHIFTER — 5 |
| 21 | 31 |
| 12B | 2:1 MUX — 111 |
| 22B | ADDER — 6 |
| 22 | 32 |
| 13B | 2:1 MUX — 112 |
| 23B | SHIFTER — 7 |
| 23 | 33 |
| 14B | 2:1 MUX — 113 |
| 24B | ADDER — 8 |
| 24 | 34 |
| 15B | 2:1 MUX — 114 |
| 25B | SHIFTER — 9 |
| 25 | 35 |

NORMAL
/TEST
INSTR.
26

115

41

36

1

# FIG. 10